# EUROPÄISCHE PATENTANMELDUNG

(11) **EP 4 847 669 A1**
(43) Veröffentlichungstag der Anmeldung: **02.12.2026**
(21) Anmeldenummer: 25178820.4
(22) Anmeldetag: 26.05.2025
(51) Int. Cl.: C30B 15/10, C30B 17/00, C30B 11/00, C30B 15/34, C30B 29/20

(54) **TIEGELSYSTEM, VERFAHREN ZU DESSEN HERSTELLUNG SOWIE DESSEN VERWENDUNG**

(71) Anmelder: Fraunhofer-Gesellschaft zur Förderung der angewandten Forschung e.V., 80686 München (DE)
(72) Erfinder: Friedrich, Jochen, 91058 Erlangen (DE); Epelbaum, Boris, 91058 Erlangen (DE); Trempa, Matthias, 91058 Erlangen (DE)
(74) Vertreter: Pfenning, Meinig & Partner mbB

(57) **Zusammenfassung**

Die vorliegende Erfindung betrifft ein Tiegelsystem umfassend einen Basistiegel aus Graphit mit mindestens einer Innenfläche und mindestens einer Außenfläche, mindestens eine zumindest auf der gesamten mindestens einen Innenfläche des Basistiegels angeordnete Schutzschicht umfassend oder bestehend aus mindestens einem Refraktärmetallcarbid, sowie mindestens eine zumindest auf einem Teil der mindestens einen Schutzschicht angeordnete abnehmbare Folie umfassend oder bestehend aus mindestens einem Refraktärmetall, wobei die mindestens eine Folie zumindest den auf der mindestens einen Innenfläche des Basistiegels angeordneten Teil der mindestens einen Schutzschicht bedeckt. Zudem betrifft die vorliegende Erfindung auch ein Verfahren zur Herstellung des Tiegelsystems sowie die Verwendung des Tiegelsystems und ein Verfahren unter Verwendung des Tiegelsystems.

## Beschreibung

Die vorliegende Erfindung betrifft ein Tiegelsystem umfassend einen Basistiegel aus Graphit mit mindestens einer Innenfläche und mindestens einer Außenfläche, mindestens eine zumindest auf der gesamten mindestens einen Innenfläche des Basistiegels angeordnete Schutzschicht umfassend oder bestehend aus mindestens einem Refraktärmetallcarbid, sowie mindestens eine zumindest auf einem Teil der mindestens einen Schutzschicht angeordnete abnehmbare Folie umfassend oder bestehend aus mindestens einem Refraktär-metall, wobei die mindestens eine Folie zumindest den auf der mindestens einen Innenfläche des Basistiegels angeordneten Teil der mindestens einen Schutzschicht bedeckt. Zudem betrifft die vorliegende Erfindung auch ein Verfahren zur Herstellung des Tiegelsystems sowie die Verwendung des Tiegelsystems und ein Verfahren unter Verwendung des Tiegelsystems.

Die Prozessierung hochschmelzender Materialien, insbesondere die Herstellung hochschmelzender Gläser, die Reinigung hochschmelzender Materialien oder die Herstellung von Einkristallen hochschmelzender Materialien erfordert kostengünstige Tiegelsysteme aus Materialien, die bei den Prozessierungstemperaturen von größer 1800 °C thermisch und chemisch stabil sind und die zu prozessierenden Materialien nicht oder in nur geringem Maße verunreinigen.

Üblicherweise werden für die Prozessierung hochschmelzender Materialien Tiegel aus Refraktär-Metallen wie Molybdän oder Wolfram und deren Legierungen verwendet. Die Herstellung entsprechender, hochreiner Refraktärmetalltiegel ist aber aufwendig und teuer. Außerdem kann die mechanische Stabilität dieser Refraktärmetalltiegel durch chemische Reaktionen zwischen dem Tiegelmaterial mit der Schmelze oder der Ofenatmosphäre beeinträchtigt werden bzw. können das Tiegelmaterial oder die Ofenatmosphäre zu Verunreinigungen des hochschmelzenden Materials führen und somit die Qualität und Ausbeute des Herstellungsprozesses mindern. Bei der Herstellung dieser hochschmelzenden Materialien kann es ferner passieren, dass sich das herzustellende Material nach der Prozessierung nicht mehr einfach vom Tiegel entfernen lässt und der Tiegel zum Entfernen des hochschmelzenden Materials teilweise oder ganz zerstört werden muss.

Aus diesem Grund sind Tiegelsysteme Stand der Technik, die aus einem Basistiegel bestehen, die dann auf der Innenseite oder Außenseite des Tiegels mit einer dünnen Beschichtung aus einem Refraktärmetall oder einer Refraktärmetalllegierung versehen sind, die entweder direkt auf die entsprechenden Tiegelwände aufgebracht werden oder ohne mechanische Verbindung mit Hilfe einer dünnen Folie ausgekleidet bzw. bedeckt werden. Der Basistiegel besteht in den meisten Fällen ebenfalls aus einem Refraktärmetall oder einer Refraktärmetalllegierung, aber teilweise sind auch Oxidkeramiken oder Graphit als Materialien offenbart.

In der US 2015/0128849 A1 wird beispielsweise ein Tiegel für die Herstellung von Saphirkristallen beschrieben, der aus Molybdän oder einer Molybdän Legierung mit > 95% Molybdän besteht und sich dadurch auszeichnet, dass er an der Innenseite eine Schicht mit einer Porosität > 5 Vol.% aufweist. Die Schicht besteht aus reinem Molybdän oder Wolfram, Molybdän/Wolfram-Legierungen oder Molybdän-/Aluminiumoxid-Verbundwerkstoffen, oder Wolfram-Aluminiumoxid-Verbundwerkstoffen. Das Aufbringen der Schicht erfolgt mittels Plasmaspritzen oder einer Slurry-Beschichtung mit einem Pulver aus Wolfram, Molybdän und Aluminiumoxid. Die Schicht hat die Funktion einer Separationsschicht. Aufgrund der offenen Porosität infiltriert die Schmelze beim Prozess in die Schicht, was dazu führt, dass nach dem Prozess die Schicht am Kristall haften bleibt. Die geringere Haftfestigkeit zwischen Schicht und Tiegel ermöglicht es, nach dem Prozess den Kristall mit der Schicht aus dem Tiegel zu entnehmen, ohne dass der Metalltiegel zerstört wird und somit wiederverwendet werden kann.

Die EP 2 278 050 A1 offenbart einen nicht-beschichteten Tiegel aus Wolfram, Molybdän oder einer Legierung aus Wolfram und Molybdän, dessen linearer Ausdehnungskoeffizient kleiner ist als die des herzustellenden Saphir-Einkristalls, so dass im Kristall beim Abkühlen auf Raumtemperatur weniger thermomechanische Spannungen entstehen.

Die WO 2013/020153 A1 beschreibt ein Tiegelsystem zur Kristallzucht, insbesondere eines Saphir-Einkristalls, mit einem Grundtiegel aus Wolfram, Molybdän, Rhenium oder einer Legierung dieser Materialien und einer Innenauskleidung mit einer Folie aus Wolfram, Molybdän, Rhenium oder einer Legierung dieser Materialien.

Die WO 2013/066495 A1 offenbart ein ähnliches Tiegelsystem mit einem Grundtiegel aus Molybdän oder einer Molybdän-Legierung, aber nicht mit einer Innenauskleidung, sondern mit einer Innenbeschichtung z.B. aus Ruthenium, Osmium, Rhodium oder Iridium, die z.B. durch ein ALD-Verfahren- oder ein anderes geeignetes Verfahren aufgebracht wird.

Die DE 10 2008 060 520 A1 beschreibt einen Tiegel vorzugsweise aus einem Refraktär-Metall oder aus keramischen Materialien wie Al₂O₃, ZrO₂, Y₂O₃, MgO und ein Verfahren zur Prozessierung eines hochschmelzenden Materials in diesem Tiegel, wobei der Teil der Oberfläche des Tiegels, der mit der Schmelze des hochschmelzenden Materials in Kontakt kommt, mit einer Folie bedeckt ist, welche aus einem Metall aus der Gruppe bestehend aus Hafnium, Niob, Tantal, Molybdän, Wolfram, Ruthenium, Rhenium, Osmium, Iridium und einer Legierung aus den genannten Metallen besteht.

Bei diesen Konzepten nach dem oben beschriebenen Stand der Technik wird zwar teilweise eine Wiederverwendung des Basistiegels durch die Verwendung einer dünnen Separationsbeschichtung bzw. -folie ermöglicht, jedoch sind die Material- und Herstellkosten für den Basistiegel aus den hochreinen Refraktärmetallen oder Refraktärmetalllegierung nach wie vor sehr hoch.

Im Stand der Technik sind auch Maßnahmen zur Erhöhung der mechanischen Stabilität des Tiegels bekannt, um insbesondere hohe Schmelzmassen prozessieren zu können. In diesen Fällen werden aber, keine Separationsschichten auf der Tiegelinnenseite verwendet, die ein einfaches Entfernen des Kristalls vom Tiegel ermöglichen.

Die KR 2019 0074640 A offenbart beispielsweise einen Tiegel aus Refraktär-Metall, der mechanisch stabilisiert wird durch einen Graphitstütztiegel. Dadurch ist es möglich, dass der Tiegel grundsätzlich für große Schmelzmassen verwendet werden kann. Jedoch kann der Graphitstütztiegel zum Eindiffundieren von Kohlenstoff in den Refraktärmetalltiegel führen.

Deshalb wird in AT 15378 U1 ein Tiegelsystem beschrieben, das aus einem Basistiegel aus einem auf Wolfram oder Molybdän basierenden Werkstoff besteht und sich dadurch auszeichnet, dass an der Außenseite des Tiegels und/oder im Tiegel zumindest abschnittsweise eine Sperrschicht aus einem metallischen Werkstoff basierend auf Tantal, Niob oder Titan ausgebildet ist. Die Sperrschicht verhindert das Eindiffundieren von Sauerstoff und Kohlenstoff aus der Ofenatmosphäre in den Basistiegel, welches die mechanische und thermische Stabilität des Basistiegels beeinträchtigen würde. Das Aufbringen der Sperrschicht kann durch Beschichtung mit metallischem Pulver nach dem Kaltgasspritz-Verfahren, dem Vakuum-Plasma-Verfahren, dem PVD Verfahren oder dem Slurry-Verfahren erfolgen. Durch Wechselwirkung mit Kohlenstoff beim Einsatz des Tiegels wandelt sich die Sperrschicht in eine kohlenstoffhaltige Metallschicht z.B. TaC um. Außerdem wird berichtet, dass auf der Sperrschicht nochmals eine Deckschicht z.B. aus Wolfram oder Molybdän an der dem Ofenraum zugewandten Seite des Tiegels aufgebracht werden kann.

Die Verwendung eines Graphit-Tiegels offenbart EP 2 902 534 A1. Graphit kann jedoch nicht direkt mit hochschmelzenden Oxidschmelzen in Kontakt gebracht werden, da es zu chemischen Reaktionen kommt, die sowohl die Stabilität des Graphittiegels herabsetzen als auch zu einer Kontamination der Schmelze mit Kohlenstoff führen. Deshalb ist der Graphit-Tiegel, der einen Ausdehnungskoeffizienten zwischen 2.0 * 10⁻⁶ bis 8.0 * 10⁻⁶ 1/K besitzt, an der Innenseite mit einem Refraktär-Metall aus der Gruppe Wolfram, Molybdän, Hafnium, Niob, Tantal, Ruthenium, Rhenium, Osmium, Iridium oder aus einer Legierung davon mit einem Ausdehnungskoeffizienten zwischen 4.5 * 10⁻⁶ bis 6.5 * 10⁻⁶ 1/K beschichtet. Die Schicht, die mittels chemischer Gasphasenabscheidung (CVD), physikalischer Gasphasenabscheidung (PVD), Vakuum-Plasmaspritzen (VPS), Sputtern oder Galvanisieren aufgebracht werden kann, hat hier die Funktion einer Separationsschicht, um nach der Prozessierung das hochschmelzende Material aus dem Tiegel entnehmen zu können. Jedoch führt auch hier der Kontakt zwischen der Refraktärmetallschicht und dem Graphit zum Eindiffundieren von Kohlenstoff in die Refraktärmetallschicht und der Bildung von Metallcarbiden, welche im Gegensatz zum reinen Refraktär-metall chemisch gegenüber den Oxidschmelzen nicht stabil sind.

Ausgehend hiervon war es die Aufgabe der vorliegenden Erfindung ein Tiegelsystem bereitzustellen, welches eine kostengünstige Herstellung von hochschmelzendem Kristallmaterial ermöglicht.

Diese Aufgabe wird bezüglich eines Tiegelsystems mit den Merkmalen des Patentanspruchs 1 und bezüglich eine Verfahrens zur Herstellung des Tiegelsystems mit den Merkmalen des Patentanspruchs 8 gelöst. Patentanspruch 11 betrifft erfindungsgemäße Verwendungen des Tiegelsystems. Die abhängigen Patentansprüche stellen vorteilhafte Weiterbildungen dar.

Erfindungsgemäß wird somit ein Tiegelsystem bereitgestellt, umfassend einen Basistiegel aus Graphit mit mindestens einer Innenfläche und mindestens einer Außenfläche, mindestens eine zumindest auf der gesamten mindestens einen Innenfläche des Basistiegels angeordnete Schutzschicht umfassend oder bestehend aus mindestens einem Refraktärmetallcarbid, sowie mindestens eine zumindest auf einem Teil der mindestens einen Schutzschicht angeordnete abnehmbare Folie umfassend oder bestehend aus mindestens einem Refraktärmetall, wobei die mindestens eine Folie zumindest den (gesamten) auf der mindestens einen Innenfläche des Basistiegels angeordneten Teil der mindestens einen Schutzschicht bedeckt.

Das erfindungsgemäße Tiegelsystem umfasst somit einen Basistiegel, mindestens eine Schutzschicht sowie mindestens eine abnehmbare Folie. Der Basistiegel besteht aus Graphit und weist mindestens eine Innenfläche und mindestens eine Außenfläche auf. Die mindestens eine Schutzschicht ist zumindest auf der gesamten mindestens einen Innenfläche (d.h. zumindest auf der gesamten inneren Oberfläche) des Basistiegels angeordnet und umfasst mindestens ein Refraktärmetallcarbid oder besteht daraus. Die mindestens eine abnehmbare Folie ist zumindest auf einem Teil der mindestens einen Schutzschicht angeordnet und umfasst mindestens ein Refraktärmetall oder besteht daraus. Zudem bedeckt die mindestens eine Folie zumindest den (gesamten) auf der mindestens einen Innenfläche des Basistiegels angeordneten Teil der mindestens einen Schutzschicht. Der mit der mindestens einen Schutzschicht beschichtete Basistiegel ist somit zumindest an seiner (gesamten) mindestens einen Innenfläche mit der mindestens einen Folie ausgekleidet.

Die mindestens eine Innenfläche des Basistiegels kann auch als innere Oberfläche des Basistiegels bezeichnet werden. Somit kann die gesamte mindestens eine Innenfläche des Basistiegels auch als gesamte innere Oberfläche des Basistiegels bezeichnet werden. Die mindestens eine Außenfläche des Basistiegels kann auch als äußere Oberfläche des Basistiegels bezeichnet werden. Somit kann die gesamte mindestens eine Außenfläche des Basistiegels auch als gesamte äußere Oberfläche des Basistiegels bezeichnet werden.

Im Gegensatz zu einer (z.B. mittels CVD-Verfahren, PVD-Verfahren, oder Slurry-Beschichtungsverfahren aufgebrachten) Beschichtung ist die im Tiegelsystem vorhandene mindestens eine Folie abnehmbar und kann somit (durch einfaches Abnehmen) vom Tiegelsystem entfernt nehmen, ohne dass der restliche Teil des Tiegelsystems beschädigt wird. Die mindestens eine Folie ist somit weder mit der mindestens einen Schutzschicht noch mit dem Basistiegel stoffschlüssig (bzw. mechanisch) verbunden. Da die mindestens eine Folie abnehmbar ist kann nach einer Verwendung des Tiegels zur Herstellung von hochschmelzendem Kristallmaterial das Kristallmaterial einfach zusammen mit der mindestens einen Folie aus dem (mit der mindestens einen Schutzschicht beschichteten) Basistiegel entfernt werden, ohne dass dieser beschädigt oder gar zerstört wird, sodass der (mit der mindestens einen Schutzschicht beschichtete) Basistiegel danach wieder verwendet werden kann. Letztlich kann somit der Basistiegel mit der darauf angeordneten Schutzschicht mehrfach zur Herstellung von hochschmelzendem Kristallmaterial verwendet werden, wodurch das hochschmelzende Kristallmaterial besonders kostengünstig hergestellt werden kann. Zudem ist aufgrund des Basistiegels aus Graphit auch das Tiegelsystem an sich sehr kostengünstig, was ebenfalls zu einer kostengünstigen Herstellung von hochschmelzendem Kristallmaterial mit dem Tiegelsystem beiträgt.

Die mindestens eine Schutzschicht hat zunächst die Funktion, die Ausdiffusion von Kohlenstoff und anderen Verunreinigungen aus dem Basistiegel zu minimieren und somit eine Kontamination des zu prozessierenden hochschmelzenden Kristallmaterials mit Stoffen aus dem Basistiegel zu vermeiden. Eine weitere Funktion der mindestens einen Schutzschicht besteht darin eine chemische Reaktion zwischen Kohlenstoff (aus dem Basistiegel) und dem Refraktär-Metall (aus der mindestens einen Folie) zu unterdrücken. Dadurch wird zum einen eine Reduzierung der mechanischen und chemischen Beständigkeit der mindestens einen Folie verhindert und zudem gewährleistet, dass die Folie nicht am beschichteten Tiegel anhaftet. Dies hat den Vorteil, dass wenn nach Aufschmelzen und Erstarren des hochschmelzenden Materials in dem Tiegel sich das hochschmelzende Material beim Erstarren mit der Folie verbindet, dieses feste, hochschmelzende Material auf einfache Weise aus dem Tiegel entfernt werden kann, wobei die Folie an dem hochschmelzenden Material haften bleibt und sich vom übrigen Tiegel löst. Das Entfernen des hochschmelzenden Materials zusammen mit der Folie aus dem Tiegel kann z.B. durch Stürzen des Tiegels erfolgen, so dass beides zusammen aus dem Tiegel fällt. Das Entfernen der Folie von dem hochschmelzenden Material kann ohne hohen mechanischen Aufwand, z. B. durch Abschälen oder Abziehen erfolgen.

Zudem kann durch die mindestens eine abnehmbare Folie ein direkter Kontakt zwischen dem hochschmelzenden Kristallmaterial und der mindestens einen Schutzschicht vermieden werden, was deshalb vorteilhaft ist, da es sonst bei Anwesenheit oxidischer Schmelzen bei der Prozessierung zur Bildung von Metalloxiden zwischen der Oxidschmelze und dem Material der Schutzschicht kommen würde, die die Schutzschicht zerstören und deren Wirkung aufheben. Da die mindestens eine Folie mindestens eine Refraktärmetall umfasst oder daraus besteht, ist sie chemisch gegenüber dem hochschmelzenden Material inert, sodass dieses nicht mit der mindestens einen Folie reagiert und es daher auch nicht zu einer Kontamination des hochschmelzenden Materials durch die Folie kommt. Zudem kann die mindestens eine Folie schneller, mit geringerem Materialaufwand und damit preiswerter hergestellt werden als ein kompletter Tiegel aus hochreinem Material. Hierbei kann die Folie vorzugsweise besonders dünn ausgeführt sein, um zusätzlich Materialkosten einzusparen. Ferner kann die Folie auch nur zur einmaligen Verwendung vorgesehen sein.

Das erfindungsgemäße Tiegelsystem kann vorzugsweise verwendet werden zur Prozessierung von hochschmelzenden Gläsern, aber auch für die Herstellung von Einkristallen aus hochschmelzenden Oxidmaterialien, bei denen der Kristall aus der Schmelze gezogen wird, wie beim Czochralski-, Nacken-Kyropulous-, oder EFG-Verfahren.

Das erfindungsgemäße Tiegelsystem kann vorzugsweise aus dem Basistiegel, der mindestens einen Schutzschicht und der mindestens einen abnehmbaren Folie bestehen.

Eine bevorzugte Ausführungsform des erfindungsgemäßen Tiegelsystems zeichnet sich dadurch aus, dass das mindestens eine Refraktärmetallcarbid ausgewählt ist aus der Gruppe bestehend aus Tantalcarbid, Wolframcarbid, Niobcarbid, Hafniumcarbid, Zirconiumcarbid, sowie Mischungen hiervon, wobei das mindestens eine Refraktärmetallcarbid vorzugsweise Tantalcarbid ist.

Gemäß einer weiteren bevorzugten Ausführungsform des erfindungsgemäßen Tiegelsystems ist das mindestens eine Refraktärmetall ausgewählt aus der Gruppe bestehend aus Wolfram, Molybdän, Hafnium, Niob, Tantal, Ruthenium, Rhenium, Osmium, Iridium, sowie Mischungen und Legierungen hiervon, wobei das mindestens eine Refraktärmetall vorzugsweise Wolfram ist.

Eine weitere bevorzugte Ausführungsform des erfindungsgemäßen Tiegelsystems ist dadurch gekennzeichnet, dass die mindestens eine Schutzschicht eine Dicke im Bereich von 20 µm bis 300 µm, bevorzugt im Bereich von 50 µm bis 150 µm, aufweist.

Eine weitere bevorzugte Ausführungsform des erfindungsgemäßen Tiegelsystems zeichnet sich dadurch aus, dass die mindestens eine Schutzschicht Poren aufweist, wobei vorzugsweise
- die mindestens eine Schutzschicht eine Porosität von mehr als 3 %, bevorzugt im Bereich von 5% bis 45 %, besonders bevorzugt im Bereich von 20 % bis 40 %, aufweist, und/oder
- die Poren der mindestens einen Schutzschicht eine mittlere Porengröße im Bereich von 1 µm bis 10 µm, bevorzugt im Bereich von 2 µm bis 5 µm, aufweisen.

Die Porosität der mindestens einen Schutzschicht kann beispielsweise an (polierten) Probenquerschnitten mittels Rasterelektronenmikroskopie bestimmt werden. Zum Beispiel kann hierbei die Probenoberfläche bei einer 2000-fachen Vergrößerung betrachtet und die Gesamtfläche aller im Mikroskop-Bild sichtbaren Poren im Beschichtungsgefüge (der mindestens einen Schutzschicht) ins Verhältnis zur gesamten Bildfläche gesetzt werden, wobei sich dann aus diesem Flächenverhältnis die Porosität der mindestens einen Schutzschicht in % ergibt.

Die mittlere Porengröße der Poren der mindestens einen Schutzschicht kann beispielsweise an (polierten) Probenquerschnitten mittels Rasterelektronenmikroskopie bestimmt werden. Zum Beispiel kann hierbei die Probenoberfläche bei einer 2000-fachen Vergrößerung betrachtet und die mittlere Porengröße der (bzw. aller) Poren manuell oder mit einer geeigneten automatisierten Bildauswertung bestimmt werden.

Gemäß einer weiteren bevorzugten Ausführungsform des erfindungsgemäßen Tiegelsystems weist die mindestens eine Folie eine Dicke im Bereich von 20 µm bis 1000 µm, bevorzugt von 50 µm bis 150 µm, auf.

Eine weitere bevorzugte Ausführungsform des erfindungsgemäßen Tiegelsystems ist dadurch gekennzeichnet, dass die mindestens eine Schutzschicht auf der gesamten Oberfläche des Basistiegels angeordnet ist und/oder die mindestens eine Folie nur auf dem (gesamten) auf der mindestens einen Innenfläche des Basistiegels angeordneten Teil der mindestens einen Schutzschicht angeordnet ist. Dadurch, dass die mindestens eine Schutzschicht auf der gesamten Oberfläche des Basistiegels angeordnet ist, ist der gesamte Tiegel durch die mindestens eine Schutzschicht langfristig sehr gut vor äußeren Einflüssen geschützt und kann somit sehr häufig wiederverwendet werden. Dadurch, dass die die mindestens eine Folie nur auf dem (gesamten) auf der mindestens einen Innenfläche des Basistiegels angeordneten Teil der mindestens einen Schutzschicht angeordnet ist, können zusätzlich Kosten eingespart werden, da die vergleichsweise teure Folie mit dem mindesten einen Refraktärmetall nur auf dem Bereich angeordnet ist, wo bei der Verwendung des Tiegelsystems hochschmelzendes Material mit dem Tiegelsystem in Berührung kommt.

Ganz besonders bevorzugt ist die mindestens eine Schutzschicht auf der gesamten Oberfläche des Basistiegels angeordnet, wobei die mindestens eine Folie nur auf dem (gesamten) auf der mindestens einen Innenfläche des Basistiegels angeordneten Teil der mindestens einen Schutzschicht angeordnet ist.

Eine weitere bevorzugte Ausführungsform des erfindungsgemäßen Tiegelsystems zeichnet sich dadurch aus, dass der Basistiegel zumindest abschnittweise zylindrisch oder abschnittsweise zylindrisch und abschnittsweise konisch ist. Ebenso kann der Basistiegel eine rechteckige, insbesondere eine quadratische, Form aufweisen.

Eine weitere bevorzugte Ausführungsform des erfindungsgemäßen Tiegelsystems ist dadurch gekennzeichnet, dass das Tiegelsystem einen Innendurchmesser im Bereich von 40 mm bis 50 mm und/oder eine Höhe im Bereich von 80 mm bis 150 mm aufweist.

Die vorliegende Erfindung betrifft zudem ein Verfahren zur Herstellung des erfindungsgemäßen Tiegelsystems, bei welchem
a) ein Basistiegel aus Graphit mit mindestens einer Innenfläche und mindestens einer Außenfläche bereitgestellt wird,
b) mindestens eine Schutzschicht umfassend oder bestehend aus mindestens einem Refraktärmetallcarbid zumindest auf mindestens einer Innenfläche des Basistiegels aufgebracht wird, und
c) mindestens eine Folie umfassend oder bestehend aus mindestens einem Refraktärmetall zumindest auf einen Teil der mindestens einen Schutzschicht angeordnet wird, wobei zumindest der auf der mindestens einen Innenfläche des Basistiegels angeordnete Teil der mindestens einen Schutzschicht durch die mindestens eine Folie bedeckt wird.

Eine bevorzugte Ausführungsform des erfindungsgemäßen Verfahrens zeichnet sich dadurch aus, dass in Schritt b) die mindestens eine Schutzschicht dadurch aufgebracht wird, dass mindestens eine wässrige Suspension umfassend Partikel enthaltend oder bestehend aus dem mindestens einen Refraktärmetallcarbid zumindest auf die mindestens eine Innenfläche des Basistiegels aufgebracht wird und danach die aufgebrachte wässrige Suspension mindestens einer Wärmebehandlung unterzogen wird, wobei vorzugsweise
- das Aufbringen der mindestens einen wässrigen Suspension mittels Sprühen erfolgt, und/oder
- die mindestens eine Wärmebehandlung bei einer Temperatur im Bereich von 1800 °C bis 2600 °C, bevorzugt im Bereich von 2200 °C bis 2300 °C, und/oder über eine Dauer von 1 h bis 10 h, bevorzugt von 3 h bis 5 h, erfolgt.

Gemäß einer weiteren bevorzugten Ausführungsform des erfindungsgemäßen Verfahrens wird beim Anordnen der mindestens einen Folie in Schritt c) die mindestens eine Folie im Wesentlichen formschlüssig auf dem zumindest einen Teil der mindestens einen Schutzschicht angeordnet (bzw. im Wesentlichen formschlüssig in den die mindestens eine Schutzschicht aufweisenden Basistiegel eingebracht). Unter einem im Wesentlichen formschlüssigen Anordnen kann dabei verstanden werden, dass der nach der Einbringung entstehende lokale Abstand zwischen der Folie und den (beschichteten) Tiegelinnenwänden respektive dem (beschichteten) Tiegelboden kleiner 1 mm, bevorzugt kleiner 0,5 mm, besonders bevorzugt kleiner 0,3 mm ist.

Eine bevorzugte Ausführungsform des erfindungsgemäßen Verfahrens zeichnet sich dadurch aus, dass das mindestens eine Refraktärmetallcarbid ausgewählt ist aus der Gruppe bestehend aus Tantalcarbid, Wolframcarbid, Niobcarbid, Hafniumcarbid, Zirconiumcarbid, sowie Mischungen hiervon, wobei das mindestens eine Refraktärmetallcarbid vorzugsweise Tantalcarbid ist.

Gemäß einer weiteren bevorzugten Ausführungsform des erfindungsgemäßen Verfahrens ist das mindestens eine Refraktärmetall ausgewählt aus der Gruppe bestehend aus Wolfram, Molybdän, Hafnium, Niob, Tantal, Ruthenium, Rhenium, Osmium, Iridium, sowie Mischungen und Legierungen hiervon, wobei das mindestens eine Refraktärmetall vorzugsweise Wolfram ist.

Die vorliegende Erfindung betrifft ferner die Verwendung des erfindungsgemäßen Tiegelsystems zur Prozessierung hochschmelzender Materialien, insbesondere zur Herstellung hochschmelzender Gläser, Reinigung hochschmelzender Materialien, Herstellung von hochschmelzendem Kristallmaterial (z.B. hochschmelzendem kristallinem Oxidmaterial), bevorzugt von Einkristallen hochschmelzender Materialien, ganz besonders bevorzugt von Einkristallen hochschmelzender Oxidmaterialien.

Eine bevorzugte Ausführungsform der erfindungsgemäßen Verwendung zeichnet sich dadurch aus, dass das Tiegelsystem zur Herstellung von Einkristallen hochschmelzender Materialien, bevorzugt Oxidmaterialien, z.B. Saphir, verwendet wird, wobei die Herstellung der Einkristalle vorzugsweise gemäß einem Verfahren erfolgt, bei dem der Einkristall aus der Schmelze gezogen wird, besonders bevorzugt gemäß einem Verfahren ausgewählt aus der Gruppe bestehend aus Czochralski-Verfahrem, Nacken-Kyropulous-Verfahren, EFG-Verfahren ("Edge-defined Film-fed Growth"-Verfahren), sowie Kombinationen hiervon.

Eine weitere bevorzugte Ausführungsform der erfindungsgemäßen Verwendung ist dadurch gekennzeichnet, dass sie die Verwendung des erfindungsgemäßen Tiegelsystems zur Herstellung von hochschmelzendem Kristallmaterial (z.B. hochschmelzendem kristallinem Oxidmaterial), bevorzugt von Einkristallen hochschmelzender Materialien, ganz besonders bevorzugt von Einkristallen hochschmelzender Oxidmaterialien betrifft, wobei
i) das mindestens eine Tiegelsystem mit einem Keim des hochschmelzenden Kristallmaterials sowie polykristallinem Ausgangsmaterial des hochschmelzenden Kristallmaterials beschickt wird,
ii) das im mindestens einen Tiegelsystem befindliche polykristalline Ausgangsmaterial bis zum Keim aufgeschmolzen wird, und
iii) das aufgeschmolzene Material in umgekehrter Richtung gerichtet erstarrt wird.

Hierbei ist es bevorzugt, dass
- die gerichtete Erstarrung in Schritt iii) gemäß einem Verfahren erfolgt, welches ausgewählt ist aus der Gruppe bestehende aus dem HEM-Verfahren ("Heat Exchanger Method"), dem VB-Verfahren ("Vertical-Bridgman"-Verfahren), dem HB-Verfahren ("Horizontal-Bridgman"-Verfahren), dem VGF-Verfahren ("Vertical-Gradient-Freeze"-Verfahren, dem HGF-Verfahren ("Horizontal-Gradient-Freeze"-Verfahren), dem HDS-Verfahren ("Horizontal-Directional-Solidification"-Verfahren), sowie Kombinationen hiervon, und/oder
- das mindestens eine Tiegelsystem mehrere Tiegelsysteme umfasst, wobei die mehreren Tiegelsysteme innerhalb einer Ofenanlage in einer Ebene angeordnet sind, wobei vorzugsweise die mehreren Tiegelsysteme in einem Suszeptor aus Graphit angeordnet sind, und/oder
- es sich bei dem hochschmelzenden Kristallmaterial um Saphirkristallmaterial handelt, besonders bevorzugt um Saphirkristalle mit endnahen Abmessungen für die Uhrenindustrie.

Im Weiteren betrifft die vorliegende Erfindung auch ein Verfahren zur Herstellung von hochschmelzendem Kristallmaterial (z.B. hochschmelzendem kristallinem Oxidmaterial), bevorzugt von Einkristallen hochschmelzender Materialien, ganz besonders bevorzugt von Einkristallen hochschmelzender Oxidmaterialien, unter Verwendung mindestens eines erfindungsgemäßen Tiegelsystems, bei welchem
i) das mindestens eine Tiegelsystem mit einem Keim des hochschmelzenden Kristallmaterials sowie polykristallinem Ausgangsmaterial des hochschmelzenden Kristallmaterials beschickt wird,
ii) das im mindestens einen Tiegelsystem befindliche polykristalline Ausgangsmaterial bis zum Keim aufgeschmolzen wird, und
iii) das aufgeschmolzene Material in umgekehrter Richtung gerichtet erstarrt wird.

Hierbei ist es bevorzugt, dass
- die gerichtete Erstarrung in Schritt iii) gemäß einem Verfahren erfolgt, welches ausgewählt ist aus der Gruppe bestehende aus dem HEM-Verfahren ("Heat Exchanger Method"), dem VB-Verfahren ("Vertical-Bridgman"-Verfahren), dem HB-Verfahren ("Horizontal-Bridgman"-Verfahren), dem VGF-Verfahren ("Vertical-Gradient-Freeze"-Verfahren, dem HGF-Verfahren ("Horizontal-Gradient-Freeze"-Verfahren), dem HDS-Verfahren ("Horizontal-Directional-Solidification"-Verfahren), sowie Kombinationen hiervon, und/oder
- das mindestens eine Tiegelsystem mehrere Tiegelsysteme umfasst, wobei die mehreren Tiegelsysteme innerhalb einer Ofenanlage in einer Ebene angeordnet sind, wobei vorzugsweise die mehreren Tiegelsysteme in einem Suszeptor aus Graphit angeordnet sind, und/oder
- es sich bei dem hochschmelzenden Kristallmaterial um Saphirkristallmaterial handelt, besonders bevorzugt um Saphirkristalle mit endnahen Abmessungen für die Uhrenindustrie.

Das erfindungsgemäße Tiegelsystem eignet sich insbesondere für die gerichtete Erstarrung von hochschmelzenden Kristallmaterialien wie Saphir nach dem HEM-, VB-, HB-, VGF- und HGF-Verfahren. Hierbei kann der Basistiegel aus Graphit bevorzugt einen thermischen Ausdehnungskoeffizienten größer als das hochschmelzende Kristallmaterial haben, damit beim Abkühlen keine thermomechanischen Spannungen in dem Kristallmaterial durch den Tiegel verursacht werden. Der beschichtete und mit der Folie ausgekleidete Tiegel kann mit einem Keim und dem polykristallinem Ausgangsmaterial des hochschmelzenden Kristallmaterials beschickt werden. Nach Einbringen des so beladenen Tiegelsystems in eine Ofenanlage kann das Material kontrolliert bis zum Keim aufgeschmolzen und anschließend kontrolliert in umgekehrter Richtung gerichtet erstarrt werden. Beim Aufschmelzen und Erstarren des hochschmelzenden Kristallmaterials in dem Tiegel verbindet sich der Kristall mit der Folie. Zum Entfernen des hochschmelzenden Kristallmaterials zusammen mit der Folie aus dem Tiegel kann der Tiegel gestürzt werden, so dass beides zusammen aus dem Tiegel fällt. Das Entfernen der Folie kann dann durch Abschälen oder Abziehen erfolgen. Der beschichtete Basistiegel ist somit wiederverwendbar und unterliegt keinem Verschleiß, während die Auskleidung des Tiegels mit der Folie nach jedem Prozess erneut erfolgen muss.

Das erfindungsgemäße Tiegelsystem eignet sich besonders hervorragend für die gerichtete Erstarrung von Saphirkristallen mit endnahen Abmessungen für die Uhrenindustrie in einer Mehrtiegelanordnung aus dem Tiegelsystem. In der Uhrenindustrie werden Saphirkristalle mit nur 40 bis 50mm Durchmesser benötigt, die dann zu Uhrengläser und Uhrengehäuse mit Dicken von wenigen Millimetern weiterverarbeitet werden. Bisher erfolgt die Produktion dieser Saphirkristalle mit der Verneuil- oder EFG-Methode, jedoch mit geringen Ausbeuten und Kristallqualitäten. Die HEM- oder Kyropulous-Methode, die Stand der Technik für die Herstellung von bis zu 200 kg schweren Saphirkristallen als Substratmaterial für die LED-Industrie ist, eignet sich nicht aufgrund der zu hohen Kosten für die massiven Tiegel aus Refraktär-Metallen, der zu langen Prozesszeiten für die Erstarrung der großen Schmelzeinwaagen und der zu hohen Materialverluste und Prozesszeiten für die Vereinzelung der großen Kristalle in die für die Uhrengläser und Uhrengehäuse benötigten Abmessungen, obwohl die HEM- und Kyropulous-Methoden Saphirkristalle mit der höchsten Materialqualität ermöglicht. Unter Verwendung des erfindungsgemäßen Tiegelsystems können nun die für die Uhrenindustrie vorhandenen Nachteile überwunden werden und Saphirkristalle mit höchster Qualität und endnahen Abmessungen kostengünstig hergestellt werden. Dazu können z.B. zylindrische, leicht konische Basistiegel aus Graphit verwendet werden, die mit der mindestens eine Schutzbeschichtung beschichtet und mit der mindestens einen Folie ausgekleidet werden. Der Innendurchmesser der beschichteten und mit Folie ausgekleideten Tiegel kann an die Dimension der herzustellenden Uhrengläser und Uhrengehäuse, als z.B. 40 bis 50 mm, angepasst sein. Die Tiegelhöhe kann so gewählt sein, dass unter Verwendung von stückigen Saphirbrocken nach dem Aufschmelzen eine Schmelzhöhe und damit finale Kristallhöhe von z.B. etwa 80 bis 150 mm resultiert. Vorzugsweise werden in der Ofenanlage mehrere beladene Tiegel in einer Ebene angeordnet. Bevorzugt befinden sich die Tiegelsysteme in einem Suszeptor aus dem gleichen Graphitwerkstoff wie der Basistiegel. Dadurch wird eine Homogenisierung des Temperaturfeldes in der horizontalen Ebene erwirkt, so dass sich z.B. die Schmelztemperatur und damit die Erstarrungsfront in allen Tiegeln auf der gleichen vertikalen Höhe befindet und der Erstarrungsprozess in allen Tiegeln gleich abläuft.

Anhand der nachfolgenden Figuren und Beispiele soll die vorliegende Erfindung näher erläutert werden, ohne die Erfindung auf die hier gezeigten spezifischen Ausführungsformen und Parameter zu beschränken.

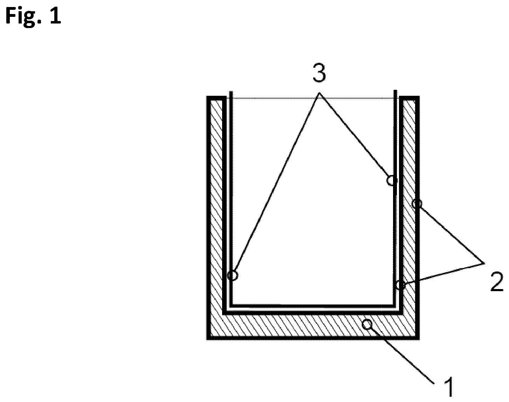

In Fig. 1 ist eine beispielhafte Ausführungsform des erfindungsgemäßen Tiegelsystems in einer schematischen Querschnittsdarstellung gezeigt. Das Tiegelsystem umfasst einen Basistiegel 1, eine Schutzschicht 2 sowie eine abnehmbare Folie 3. Der Basistiegel 1 besteht aus Graphit und weist eine Innenfläche und eine Außenfläche auf, wobei die Schutzschicht 2 auf der gesamten Oberfläche des Basistiegels 1 angeordnet ist und mindestens ein Refraktärmetallcarbid umfasst oder daraus besteht. Die abnehmbare Folie 3 ist nur auf dem (gesamten) auf den Innenflächen des Basistiegels 1 angeordneten Teil der Schutzschicht 2 angeordnet und umfasst mindestens ein Refraktärmetall oder besteht daraus. Somit bedeckt die Folie 3 (nur) den (gesamten) auf den Innenflächen des Basistiegels 1 angeordneten Teil der Schutzschicht 2. Der mit der Schutzschicht 2 beschichtete Basistiegel 1 ist also (nur) an seinen (gesamten) Innenflächen mit der Folie 3 ausgekleidet. Die Schutzschicht 2 kann z.B. aus Tantalcarbid bestehen, d.h. bei der Schutzschicht 2 kann es sich um eine Tantalcarbid-Schutzschicht handeln. Die abnehmbare Folie 3 kann beispielsweise aus Wolfram bestehen, d.h. bei der abnehmbaren Folie 3 kann es sich um eine abnehmbare Wolframfolie handeln.

### Ausführungsbeispiel 1:

### Wachstum von Saphir-Kristallen mittels Horizontal-Gradient-Freeze Verfahren

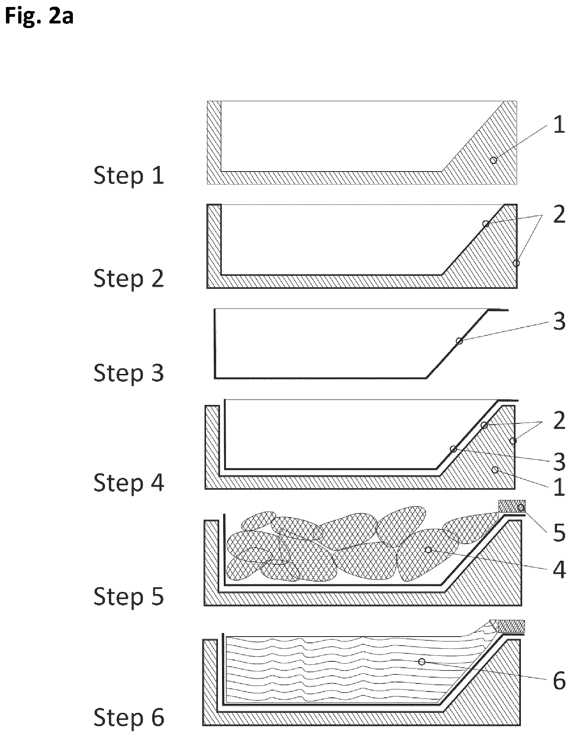

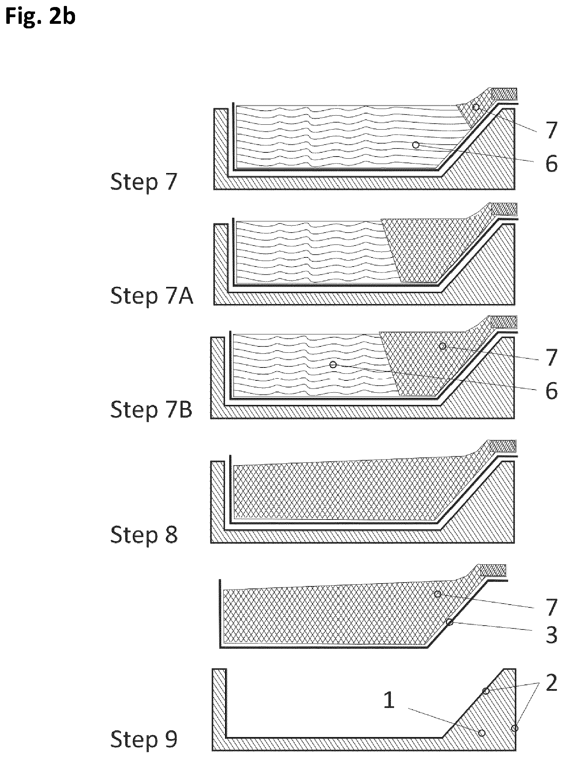

Die einzelnen Prozessschritte sind in Fig. 2a und 2b dargestellt.

In Schritt 1 wird ein Basistiegel 1 bereitgestellt, bei dem es sich um einen wannenartigen, rechteckigen Graphit-Tiegel handelt, der aus einem isostatisch gepressten Graphitmaterial hergestellt werden kann.

In Schritt 2 wird eine wässrige Suspension, die Refraktärmetallcarbid-Partikel (z.B. TaC-Partikel) enthält, auf den Basistiegel 1 gesprüht, so dass die kompletten Innenflächen des Basistiegels 1 mit einer geschlossenen Schutzschicht 2 in Form einer Refraktärmetallcarbid-Schicht (z.B. TaC-Schicht) von ca. 100 bis 150 µm Dicke belegt sind. In einem anschließenden Wärmebehandlungsprozess wird die aufgebrachte Schutzschicht 2 bei Temperaturen von über 2000 °C für mehrere Stunden gesintert, um die finalen Schichteigenschaften zu erzeugen und die Haftung zum Basistiegel 1 zu gewährleisten.

Im Schritt 3 wird eine Folie 3, bei welcher es sich um eine 100 µm dicke Refraktärmetall-Folie, z.B. Wolframfolie oder Molybdänfolie, handelt, vorsichtig zurechtgebogen und in die Form des Inneren des mit der Schutzschicht 2 beschichteten Basistiegels 1 gebracht.

In Schritt 4 wird die in Form gebrachte Folie 3 in den mit den Schutzschicht 2 beschichteten Basistiegel 1 möglichst formschlüssig, d.h. ohne große entstehende Hohlräume zwischen (beschichtetem) Tiegel und Folie 3, eingepasst.

In Schritt 5 wird das Tiegelsystem mit Saphir Bruchstücken 4 gefüllt. Ein einkristalliner Saphir-Keim 5 wird an der Seite des Tiegelsystems positioniert.

Im Folgenden (Schritte 6 bis 8) wird das Tiegelsystem in eine Kristallzüchtungsanlage gebracht, der Ofen aufgeheizt und ein horizontaler Temperaturgradient angelegt, in der Art, dass die Saphir-Bruchstücke 4 zu einer Saphir-Schmelze 6 aufgeschmolzen werden (Schritt 6), der Saphir-Keim 5 jedoch nur partiell angeschmolzen wird.

Durch geeignete Temperaturführung/Abkühlung erstarrt nun die Saphir-Schmelze 6, ausgehend vom Saphir-Keim 5, horizontal gerichtet im Tiegelsystem, zu einem Saphir-Kristall 7 (Schritte 7, 7A und 7b). Am Ende des Kristallisationsprozesses füllt der Saphir-Kristall 7 nahezu den kompletten Tiegel bzw. das komplette Tiegelsystem (Schritt 8).

Nach Abkühlung wird der Saphir-Kristall 7 sehr einfach aus dem Tiegelsystem entnommen (Schritt 9). Die Folie 3 haftet dabei am Saphir-Kristall 7, nicht jedoch am mit der Schutzschicht 2 beschichteten Basistiegel 1. Dies ermöglicht den Wiedereinsatz des TaC beschichteten Graphit-Tiegels, indem eine neue Refraktärmetall-Folie gemäß oben beschriebenen Schritten 3 und 4 in den mit der Schutzschicht 2 beschichteten Basistiegel 1 eingelegt wird.

Die am Saphir-Kristall 7 haftende Folie 3 wird im Folgenden einfach mechanisch entfernt, im Rahmen der ohnehin nach der Züchtung notwendigen Oberflächenbearbeitung des Saphir-Kristallmaterials.

### Ausführungsbeispiel 2:

### Multiples Wachstum von Saphir Kristallen mittels edge-defined film-fed growth (EFG)

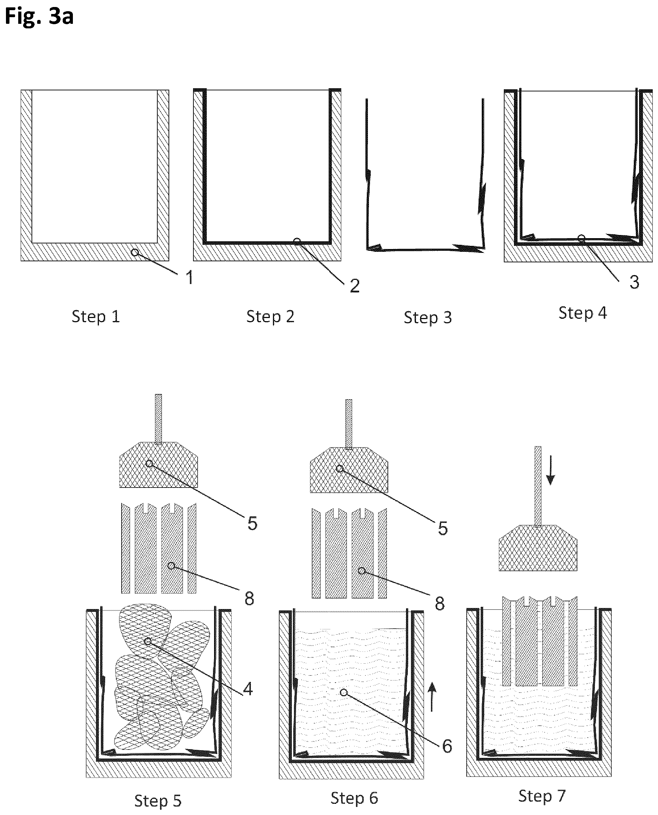

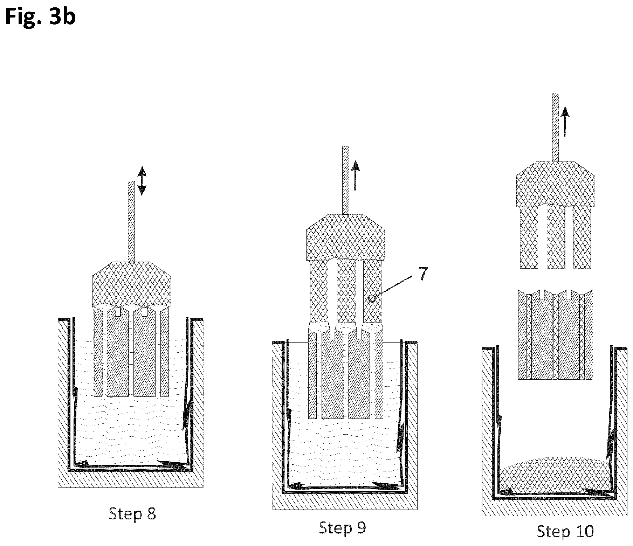

Die einzelnen Prozessschritte sind in Fig. 3a und 3b dargestellt.

In Schritt 1 wird ein Basistiegel 1 bereitgestellt, bei dem es sich um einen zylindrischen Graphit-Tiegel handelt, der aus einem isostatisch gepressten Graphitmaterial hergestellt werden kann.

In Schritt 2 wird eine wässrige Suspension, die Refraktärmetallcarbid-Partikel (z.B. TaC-Partikel) enthält, auf den Basistiegel 1 gesprüht, so dass die kompletten Innenflächen des Basistiegels 1 mit einer geschlossenen Schutzschicht 2 in Form einer Refraktärmetallcarbid-Schicht (z.B. TaC-Schicht) von ca. 100 bis 150 µm Dicke belegt sind. In einem anschließenden Wärmebehandlungsprozess wird die aufgebrachte Schutzschicht 2 bei Temperaturen von über 2000 °C für mehrere Stunden gesintert, um die finalen Schichteigenschaften zu erzeugen und die Haftung zum Basistiegel zu gewährleisten.

In Schritt 3 wird eine Folie 3, bei welcher es sich um eine 100 µm dicke Refraktärmetall-Folie, z.B. Wolframfolie oder Molybdänfolie, handelt, vorsichtig zurechtgebogen und in die Form des Inneren des mit der Schutzschicht 2 beschichteten Basistiegels 1 gebracht.

In Schritt 4 wird die in Form gebrachte Folie 3 in mit der Schutzschicht 2 beschichteten Basistiegel 1 möglichst formschlüssig, d.h. ohne große entstehende Hohlräume zwischen (beschichtetem) Tiegel und Folie, eingepasst. Die aufgrund der zylindrischen Geometrie des Tiegels entstehenden Falten/Knicke der Folie 3 sind unkritisch, da in diesem Fall der Kristall nicht im Tiegel erstarrt und somit keinen direkten Kontakt zur Folie 3 hat.

In Schritt 5 wird das Tiegelsystem mit Saphir Bruchstücken 4 gefüllt und in eine EFG-Kristallzüchtungsanlage eingebracht, zusammen mit einem Molybdänformgeber 8 und mindestens einem einkristallinen Saphir-Keim 5 an einer Ziehstange.

Anschließend wird in Schritt 6 der Ofen erwärmt, in der Art, dass die Saphir-Bruchstücke 4 zu einer Saphir-Schmelze 6 aufgeschmolzen werden, der mindestens eine Saphir-Keim 5 darüber jedoch nicht.

In Schritt 7 wird der Molybdänformgeber 8 in die Saphir-Schmelze 6 eingetaucht und fixiert. Die Saphir-Schmelze 6 steigt aufgrund der Kapillarkräfte in die Kanäle des Molybdänformgebers 8 auf.

In Schritt 8 wird der mindestens eine einkristalline Saphir-Keim 5 abgesenkt bis er in Kontakt mit der Saphir-Schmelze 6 leicht anschmilzt, jedoch nicht gänzlich aufschmilzt.

In Schritt 9 werden Saphir-Kristalle 7 in Form von Saphir-Bändern unter einer kontrollierten Geschwindigkeit mittels der Ziehstange aus der Saphir-Schmelze 6 herausgezogen.

Im finalen Schritt 10 werden der mindestens eine Saphir-Keim 5 mit den Saphir-Kristallen 7, der Molybdänformgeber 8 und das Tiegelsystem mit der Restschmelze voneinander separiert und bis Raumtemperatur abgekühlt.

Die im Tiegelsystem noch enthaltene, erstarrte Restschmelze wird zusammen mit der daran haftenden Folie 3 aus dem Tiegelsystem entnommen und verworfen.

Dies ermöglicht den Wiedereinsatz des TaC beschichteten Graphit-Tiegels, indem eine neue Refraktärmetall-Folie gemäß oben beschriebenen Schritten 3 und 4 in den mit der Schutzschicht 2 beschichteten Basistiegel 1 eingelegt wird.

## Patentansprüche

1. Tiegelsystem umfassend einen Basistiegel (1) aus Graphit mit mindestens einer Innenfläche und mindestens einer Außenfläche, mindestens eine zumindest auf der gesamten mindestens einen Innenfläche des Basistiegels (1) angeordnete Schutzschicht (2) umfassend oder bestehend aus mindestens einem Refraktärmetallcarbid, sowie mindestens eine zumindest auf einem Teil der mindestens einen Schutzschicht (2) angeordnete abnehmbare Folie (3) umfassend oder bestehend aus mindestens einem Refraktärmetall, wobei die mindestens eine Folie (3) zumindest den auf der mindestens einen Innenfläche des Basistiegels (1) angeordneten Teil der mindestens einen Schutzschicht (2) bedeckt.

2. Tiegelsystem nach dem vorhergehenden Anspruch, **dadurch gekennzeichnet, dass** das mindestens eine Refraktärmetallcarbid ausgewählt ist aus der Gruppe bestehend aus Tantalcarbid, Wolframcarbid, Niobcarbid, Hafniumcarbid, Zirconiumcarbid, sowie Mischungen hiervon, wobei das mindestens eine Refraktärmetallcarbid vorzugsweise Tantalcarbid ist.

3. Tiegelsystem nach einem der vorhergehenden Ansprüche, **dadurch gekennzeichnet, dass** das mindestens eine Refraktärmetall ausgewählt ist aus der Gruppe bestehend aus Wolfram, Molybdän, Hafnium, Niob, Tantal, Ruthenium, Rhenium, Osmium, Iridium, sowie Mischungen und Legierungen hiervon, wobei das mindestens eine Refraktärmetall vorzugsweise Wolfram ist.

4. Tiegelsystem nach einem der vorhergehenden Ansprüche, **dadurch gekennzeichnet, dass** die mindestens eine Schutzschicht (2) eine Dicke im Bereich von 20 µm bis 300 µm, bevorzugt im Bereich von 50 µm bis 150 µm, aufweist.

5. Tiegelsystem nach einem der vorhergehenden Ansprüche, **dadurch gekennzeichnet, dass** die mindestens eine Schutzschicht (2) Poren aufweist, wobei vorzugsweise
- die mindestens eine Schutzschicht (2) eine Porosität von mehr als 3 %, bevorzugt im Bereich von 5 % bis 45 %, besonders bevorzugt im Bereich von 20 % bis 40 %, aufweist, und/oder
- die Poren der mindestens einen Schutzschicht (2) eine mittlere Porengröße im Bereich von 1 µm bis 10 µm, bevorzugt im Bereich von 2 µm bis 5 µm, aufweisen.

6. Tiegelsystem nach einem der vorhergehenden Ansprüche, **dadurch gekennzeichnet, dass** die mindestens eine Folie (3) eine Dicke im Bereich von 20 µm bis 1000 µm, bevorzugt von 50 µm bis 150 µm, aufweist.

7. Tiegelsystem nach einem der vorhergehenden Ansprüche, **dadurch gekennzeichnet, dass** die mindestens eine Schutzschicht (2) auf der gesamten Oberfläche des Basistiegels (1) angeordnet ist und/oder die mindestens eine Folie (3) nur auf dem auf der mindestens einen Innenfläche des Basistiegels (1) angeordneten Teil der mindestens einen Schutzschicht (2) angeordnet ist.

8. Verfahren zur Herstellung eines Tiegelsystems gemäß einem der vorhergehenden Ansprüche, bei welchem
a) ein Basistiegel (1) aus Graphit mit mindestens einer Innenfläche und mindestens einer Außenfläche bereitgestellt wird,
b) mindestens eine Schutzschicht (2) umfassend oder bestehend aus mindestens einem Refraktärmetallcarbid zumindest auf mindestens einer Innenfläche des Basistiegels (1) aufgebracht wird, und
c) mindestens eine Folie (3) umfassend oder bestehend aus mindestens einem Refraktärmetall zumindest auf einen Teil der mindestens einen Schutzschicht (2) angeordnet wird, wobei zumindest der auf der mindestens einen Innenfläche des Basistiegels (1) angeordnete Teil der mindestens einen Schutzschicht (2) durch die mindestens eine Folie (3) bedeckt wird.

9. Verfahren nach Anspruch 8, **dadurch gekennzeichnet, dass** in Schritt b) die mindestens eine Schutzschicht (2) dadurch aufgebracht wird, dass mindestens eine wässrige Suspension umfassend Partikel enthaltend oder bestehend aus dem mindestens einen Refraktärmetallcarbid zumindest auf die mindestens eine Innenfläche des Basistiegels (1) aufgebracht wird und danach die aufgebrachte wässrige Suspension mindestens einer Wärmebehandlung unterzogen wird, wobei vorzugsweise
- das Aufbringen der mindestens einen wässrigen Suspension mittels Sprühen erfolgt, und/oder
- die mindestens eine Wärmebehandlung bei einer Temperatur im Bereich von 1800 °C bis 2600 °C, bevorzugt im Bereich von 2200 °C bis 2300 °C, und/oder über eine Dauer von 1 h bis 10 h, bevorzugt von 3 h bis 5 h, erfolgt.

10. Verfahren nach Anspruch 8 oder 9, **dadurch gekennzeichnet, dass** beim Anordnen der mindestens einen Folie (3) in Schritt c) die mindestens eine Folie (3) im Wesentlichen formschlüssig auf dem zumindest einen Teil der mindestens einen Schutzschicht angeordnet wird.

11. Verwendung eines Tiegelsystems gemäß einem der Ansprüche 1 bis 7 zur Herstellung, Prozessierung, und/oder Reinigung hochschmelzender Materialien.

12. Verwendung nach Anspruch 11, **dadurch gekennzeichnet, dass** die hochschmelzenden Materialien ausgewählt sind aus der Gruppe bestehend aus Gläsern, Kristallmaterialien, sowie Mischungen hiervon, wobei es sich bei den Kristallmaterialien vorzugsweise um Oxidmaterialien, besonders bevorzugt Saphir, handelt, wobei es sich bei den Kristallmaterialien besonders bevorzugt um Saphirkristalle mit endnahen Abmessungen für die Uhrenindustrie handelt.

13. Verwendung nach Anspruch 11 oder 12, **dadurch gekennzeichnet, dass** das Tiegelsystem zur Herstellung von Einkristallen hochschmelzender Materialien, bevorzugt von Einkristallen hochschmelzender Oxidmaterialien, besonders bevorzugt von Saphir-Einkristallen, verwendet wird, wobei die Herstellung der Einkristalle vorzugsweise
- gemäß einem Verfahren erfolgt, bei dem ein Einkristall aus einer Schmelze gezogen wird, wobei das Verfahren besonders bevorzugt ausgewählt ist aus der Gruppe bestehend aus Czochralski-Verfahren, Nacken-Kyropulous-Verfahren, EFG-Verfahren ("Edge-defined Film-fed Growth"-Verfahren), sowie Kombinationen hiervon, oder
- gemäß einem Verfahren erfolgt, bei dem ein Einkristall mittels gerichteter Erstarrung einer Schmelze entsteht, wobei das Verfahren besonders bevorzugt ausgewählt ist aus der Gruppe bestehend aus HEM-Verfahren ("Heat Exchanger Method"), VB-Verfahren ("Vertical-Bridgman"-Verfahren), HB-Verfahren ("Horizontal-Bridgman"-Verfahren), VGF-Verfahren ("Vertical-Gradient-Freeze"-Verfahren, HGF-Verfahren ("Horizontal-Gradient-Freeze"-Verfahren), HDS-Verfahren ("Horizontal-Directional-Solidification"-Verfahren), sowie Kombinationen hiervon.

14. Verwendung nach einem der Ansprüche 11 bis 13, **dadurch gekennzeichnet, dass** bei der Verwendung das hochschmelzende Material zumindest teilweise aufgeschmolzen wird, das aufgeschmolzene Material zumindest teilweise erstarrt, und das erstarrte Material zusammen mit der mindestens einen Folie (3) aus dem Tiegelsystem entfernt wird.
